Europäisches Patentamt

European Patent Office

Office européen des brevets

(11) Veröffentlichungsnummer: **0 040 678**
**A2**

(12) **EUROPÄISCHE PATENTANMELDUNG**

(21) Anmeldenummer: **81102087.4**

(22) Anmeldetag: **20.03.81**

(51) Int. Cl.³: **H 05 B 37/00,** H 01 H 43/00,
G 04 F 1/00, H 03 K 3/027

(30) Priorität: **22.05.80 DE 3019565**

(43) Veröffentlichungstag der Anmeldung: **02.12.81**
**Patentblatt 81/48**

(84) Benannte Vertragsstaaten: **AT BE CH DE FR IT LI NL SE**

(71) Anmelder: **SCHUPA ELEKTRO-GMBH + CO KG,**
**Postfach 1460 Klagebach 40, D-5885 Schalksmühle (DE)**

(72) Erfinder: **Kock, Dietrich, Wiesenstrasse 19,**
**D-5885 Schalksmühle (DE)**
Erfinder: **Meyer, Richard, Riemerschmidstrasse 14,**
**D-5800 Hagen 1 (DE)**

(54) **Treppenlichtzeitschalter.**

㉗ Die Erfindung betrifft einen Treppenlichtzeitschalter für eine wahlweise Umschaltung einer Beleuchtungsanlage von vorgewählter Einschaltzeit auf Dauerlicht. Die bekannten Treppenlichtzeitschalter weisen den Nachteil auf, daß die Funktion «Dauerlicht» nur am Gerät selbst einstellbar ist. Da diese Geräte häufig zentral installiert sind, z.B. in einem Zählerraum, bedeutet dies für den Fall einer Umschaltung auf Dauerlicht für die Bedienperson einen unzumutbaren Zeitaufwand. Die Erfindung vermeidet diesen Nachteil dadurch, daß in den Stromkreis der Beleuchtungsanlage eine Zeitgeberschaltung (T) eingeschaltet ist, bei der durch kurzzeitiges Betätigen des Treppenlichttasters (Ta) das Treppenlicht mit der vorgewählten Zeitdauer eingeschaltet wird. Bei längerem Drücken des Tasters z. B. über 5 Sekunden, erfolgt die Umschaltung auf Dauerlicht. Erst nach erneuter Betätigung durch kurzes Antippen des Tasters (Ta) und einer darauffolgenden Nachleuchtdauer der Verzögerungsschaltung erlischt die Beleuchtungsanlage.

- 1 -

## Treppenlichtzeitschalter

Die Erfindung betrifft einen Treppenlichtzeitschalter gemäß dem Oberbegriff des Anspruches 1.

Es ist bekannt, daß den Treppenlichtzeitschaltern herkömmlicher Bauweise der Nachteil anhaftet, daß die Funktion "Dauerlicht" ausschließlich am Gerät selbst einstellbar ist. Da diese Geräte vorwiegend mit anderen an einer zentralen Stelle (z.B. Zählerraum) installiert sind, bedeutet dies für den Fall einer Umschaltung auf Dauerlicht einen dem heutigen Stand der Technik nicht mehr zumutbaren Zeitaufwand für die Bedienperson.

Der Erfindung liegt die Aufgabe zugrunde, unter Vermeidung der oben geschilderten Nachteile bei einem Treppenlichtzeitschalter gemäß dem Oberbegriff des Anspruches 1 die Einsatzmöglichkeiten des Treppenlichtzeitschalters erheblich zu verbessern. Ein weiteres Ziel ist eine möglichst einfache Schaltung für einen solchen Treppenlichtzeitschalter mit diesen Eigenschaften.

Diese Aufgabe wird erfindungsgemäß durch die im kennzeichnenden Teil des Anspruchs 1 angegebenen Merkmale gelöst.

Diese Schaltung ist aus bekannten elektronischen Bausteinen so aufgebaut, daß in den Stromkreis der Beleuchtungsanlage eine Zeitgeberschaltung eingeschaltet ist, bei der durch kurzzeitiges Betätigen des Treppenlichttasters das Treppenlicht mit der vorgewählten Zeitdauer eingeschaltet wird. Falls der Taster über eine längere Zeitdauer betätigt wird, z.B. länger als 5 Sekunden, erfolgt eine Umschaltung auf Dauerlicht. Die Beleuchtungsanlage erlischt erst nach erneuter Betätigung - kurzes Antippen - des Tasters und der darauf folgenden Nachleuchtdauer der Verzögerungsschaltung.

In der nachstehenden Beschreibung werden in der Zeichnung dargestellte Ausführungsbeispiele näher beschrieben. Es zeigt:

Figur 1 den prinzipiellen Aufbau der erfindungsgemäßen Schaltung in Form eines Blockschaltbildes,

Figur 2 ein Zeitdiagramm der jeweiligen Schaltzustände,

Figur 3 ein Ausführungsbeispiel der Erfindung,

Figur 4 das Blockschaltbild einer weiteren Ausführungsform der erfindungsgemäßen Schaltung,

Figur 5 ein Ausführungsbeispiel der weiteren Ausführungsform.

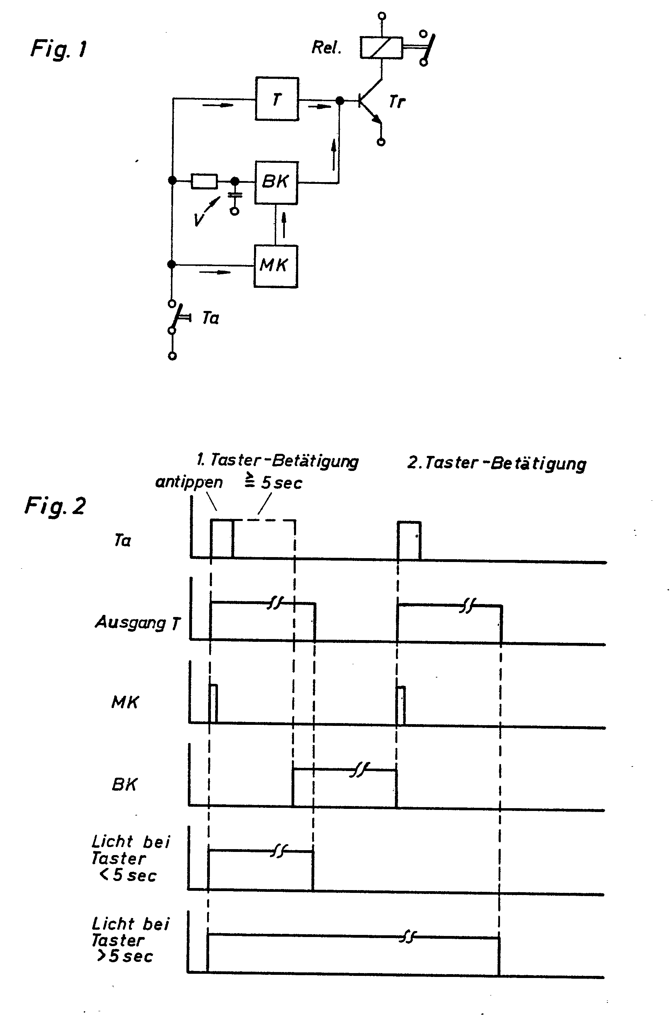

Der prinzipielle Aufbau ist in Figur 1 dargestellt. Bei jeder kurzzeitigen Betätigung des Tasters Ta wird eine Zeitgeberschaltung T und die monostabile Kippstufe MK beeinflußt. Die Zeitgeberschaltung T steuert über den Transistor Tr das Lastrelais REL an, welches eine in der Zeichnung nicht dargestellte Beleuchtungsanlage einschaltet. Die Verzögerungszeit ist vorwählbar von beispielsweise 0,5 bis 5 Min. Die monostabile Kippstufe MK gibt einen kurzzeitigen Impuls z.B. von 100 ms auf den Rücksetzeingang der bistabilen Kippstufe BK, welche jedoch noch nicht gesetzt worden ist. Erst bei einer länger dauernden Betätigung des Tasters Ta von beispielsweise 5 Sek. und darüber wird die bistabile Kippstufe BK über das Verzögerungsglied V gesetzt. Der Ausgang der bistabilen Kippstufe BK steuert nun ebenfalls den Transistor Tr an. Die Beleuchtungsanlage ist nun auch noch nach der abgelaufenen Verzögerungszeit der Zeitgeberschaltung T so lange an, bis eine erneute kurze Betätigung des Tasters die monostabile Kippstufe MK triggert, welches die bistabile Kippstufe BK zurücksetzt. Gleichzeitig wird die Zeitgeberschaltung neu gesetzt, so daß nach der Tasterbetätigung die Beleuchtungsanlage noch mit der eingestellten Verzögerungszeit leuchtet und danach erlischt.

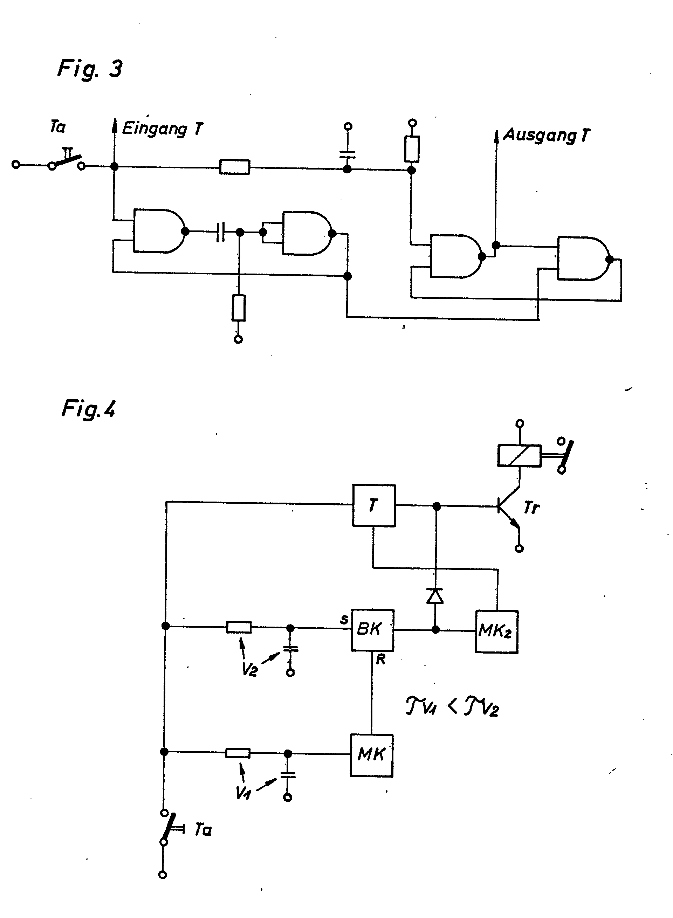

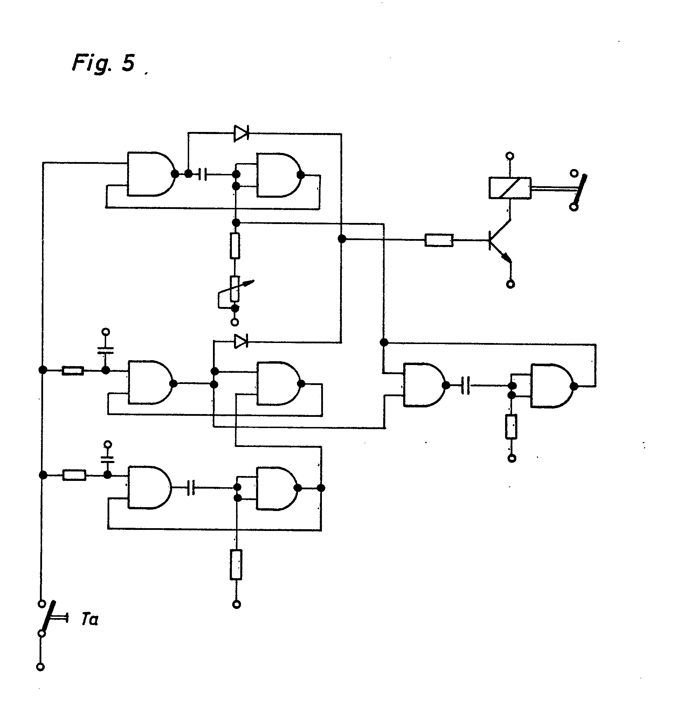

Ein weiteres Ausführungsbeispiel ist in den Figuren 4 und 5 dargestellt, es ist dadurch gekennzeichnet, daß der Schaltung entsprechend der Fig. 1 und 3 eine zweite monostabile Kippstufe MK 2 und ein Verzögerungsglied V 2 zugeschaltet ist, wodurch ein erneutes Triggern der Zeitgeberschaltung T nach der Dauerlichtfunktion vermieden wird.

Durch diese Schaltmaßnahme wird erreicht, daß die Beleuchtungsanlage bei Dauerlichtfunktion nach ca. 5 Sek. Tasterbetätigung sofort erlischt.

Patentansprüche

1. Treppenlichtzeitschalter, insbesondere für eine wahlweise Umschaltung der Beleuchtungsanlage von vorgewählter Einschaltzeit auf Dauerlicht, dadurch gekennzeichnet, daß die Umschaltung der Beleuchtungsanlage für ein Treppenhaus von einem Treppenlichtzeitschalter mit vorwählbarer Zeitdauer auf Dauerlichtfunktion durch eine Zeitgeberschaltung (T) erfolgt, bei der durch kurzzeitiges Betätigen eines Tasters (Ta) die vorgewählte Brenndauer der Beleuchtungsanlage eingeschaltet wird, wohingegen die Umschaltung auf Dauerlicht einen festgesetzten Mindestwert für die Dauer der Tasterbetätigung erfordert, während das Erlöschen der Beleuchtungsanlage erst nach erneuter kurzzeitiger Betätigung des Tasters (Ta) und der noch eingestellten Beleuchtungs-Verzögerungszeit der Zeitgeberschaltung erfolgt.

2. Treppenlichtzeitschalter nach Anspruch 1, dadurch gekennzeichnet, daß der Taster (Ta) mit einer Zeitgeberschaltung (T) und einer monostabilen Kippstufe (MK) verbunden ist, um eine Schaltung zu bilden, womit erst bei längerer Betätigung des Tasters (Ta) und mittels eines Verzögerungsgliedes (V) eine bistabile Kippstufe (BK) den Schaltzustand Dauerlicht einschaltet.

3. Treppenlichtzeitschalter nach den Ansprüchen 1 und 2, dadurch gekennzeichnet, daß der Schaltung nach den Figuren 1 und 3 eine zweite monostabile Kippstufe (MK 2) und ein Verzögerungsglied (V 2) zugeschaltet ist, wodurch ein erneutes Triggern der Zeitgeberschaltung (T) nach der Dauerlichtfunktion vermieden wird.

1/3

0040678

Fig. 1

Rel.

T    Tr

BK

V

MK

Ta

Fig. 2

1. Taster-Betätigung

antippen  ≧ 5 sec

2. Taster-Betätigung

Ta

Ausgang T

MK

BK

Licht bei
Taster
< 5 sec

Licht bei
Taster
> 5 sec

0040678

Fig. 3

Ta    ↑Eingang T      ↑Ausgang T

Fig. 4

$T_{V_1} < T_{V_2}$

**Fig. 5**

Ta